# EUROPÄISCHE PATENTSCHRIFT

(11) **EP 0 734 460 B1**
(45) Veröffentlichungstag und Bekanntmachung des Hinweises auf die Patenterteilung: **12.05.1999**
(21) Anmeldenummer: 95903234.3
(22) Anmeldetag: 15.12.1994
(51) Int. Cl.: C23C 14/22, C23C 28/00, C23C 14/06

(54) **VERFAHREN ZUR HERSTELLUNG EINER HARTSTOFFSCHICHT**
PROCESS FOR PRODUCING A HARD MATERIAL LAYER
PROCEDE DE PRODUCTION D'UNE COUCHE DE MATERIAU DUR

(30) Priorität: 18.12.1993 DE 4343354
(43) Veröffentlichungstag der Anmeldung: 02.10.1996
(73) Patentinhaber: ROBERT BOSCH GMBH, 70442 Stuttgart (DE)
(72) Erfinder: LADEWIG, Klaus, D-71272 Renningen (DE); KOHLHOF, Karl, D-70597 Stuttgart (DE); Voigt, Johannes, D - 71229 Leonberg (DE); Burger, Kurt, D - 71292 Friolzheim (DE)
(86) Internationale Anmeldenummer: DE9401491
(87) Internationale Veröffentlichungsnummer: WO9516799

(56) Entgegenhaltungen:
- EP-A- 0 166 349
- WO-A-87/04471
- FR-A- 2 592 063
- FR-A- 2 596 775
- US-A- 5 064 682
- US-A- 5 249 554
- 38TH NATIONAL SYMPOSIUM OF THE AMERICAN VACUUM SOCIETY, SEATTLE, WA, USA, 11-15 NOV. 1991, ISSN 0734-2101, JOURNAL OF VACUUM SCIENCE & TECHNOLOGY A (VACUUM, SURFACES, AND FILMS), JULY-AUG. 1992, USA, PAGE(S) 1757 - 1764 Wolf G K 'Modification of chemical properties of materials by ion beam mixing and ion beam assisted deposition'

## Beschreibung

Die Erfindung betrifft ein Verfahren zur Herstellung einer Hartstoffschicht nach dem Oberbegriff des Anspruchs 1.

### Stand der Technik

Es ist bekannt, daß bei in verschiedenen technischen Gebieten eingesetzten Bauteilen unterschiedliche, oft kombinierte Verschleißarten auftreten können. Damit die Bauteile gegen einen übermäßigen Verschleiß geschützt sind, werden diese in zunehmendem Maße mit einer Schutzschicht versehen. An diese Schutzschicht werden besondere Anforderungen gestellt. So ist beispielsweise eine gute Adhäsion zum Bauteil, eine gute Kohäsion innerhalb des Schichtverbundes sowie eine geringe Adhäsion zum Gegenkörper notwendig. Weiterhin müssen die Schutzschichten geringe innere Druckspannungen, eine hohe Härte und Tragfähigkeit, einen geringen Reibkoeffizienten und eine Oberflächenglattheit und Porenfreiheit aufweisen. Darüber hinaus ist bei bestimmten Anwendungen der Bauteile eine hohe Affinität der Schutzschicht zu Schmiermitteln zu gewährleisten.

Derartige Schutzschichten werden beispielsweise in Vakuumkammern aufgebracht, in denen ein Partikeldampf erzeugt wird. In PVD (physical vapour Deposition)-Verfahren wird dazu in der Regel die Sputter-Technologie angewendet, bei der ein als Kathode geschaltetes sogenanntes Target unter Bombardement positiver Ionen zerstäubt wird. In CVD (chemical vapour deposition)-Verfahren wird die abzuscheidende Komponente als gasförmige Verbindung in die Vakuumkammer eingeleitet. Es ist bekannt, als Schutzschichten sogenannte Hartstoffschichten in reaktiven Aufdampfprozessen abzuscheiden, die eine Kombination von PVD- und CVD-Verfahren darstellen. Die metallische Komponente wird durch Zerstäuben, die metalloiden Komponenten dagegen gasförmig eingebracht. Ein solches Partikeldampfgemisch wird in plasmaunterstützten Aufdampfverfahren teilweise ionisiert. Durch elektrische Felder werden aus den Plasmavolumina Ionen auf das Beschichtungsgut beschleunigt. Dadurch kommt es zu dem bekannten Ionenplattiereffekt, der ursächlich für gesteigerte Schichteigenschaften ist.

Aus dem Werkzeugbau ist beispielsweise bekannt, mit Hilfe solcher plasmagestützten Abscheidungsprozesse dünne Hartstoffschichten auf die Werkzeuge zu dampfen, die somit eine Verschleißschutzbeschichtung ergeben. Dabei werden im wesentlichen Titannitride (TiN), Titankarbide (TiC) und Titanboride (TiB₂) bzw. daraus abgeleitete mehrkomponentige Legierungen oder Vielfachschichtsysteme eingesetzt. Wegen ihrer hohen Härte können diese Schichten einer schlagenden Beanspruchung und einem Kavitations- sowie Abrasionsverschleiß widerstehen. Sie besitzen aber wegen des relativ hohen Reibkoeffizienten schlechte Gleiteigenschaften und sind zudem meist korrosionsanfällig. Bei der Herstellung dieser Verschleißschutzbeschichtung in Vakuumprozessen werden darüber hinaus in der Regel Temperaturen von ca. 300 bis 500 °C benötigt, die für einige Bauteilwerkstoffe zu hoch liegen. Damit ist nachteilig, daß die mit einem etablierten Verfahren aufgebrachte Schutzschicht nur für begrenzte Anwendungen in Frage kommt.

Weiterhin ist als Bauteilschutz das Aufbringen von Kohlenstoffschichten bekannt, die wegen ihres geringen Reibkoeffizienten für Gleitpaarungen besonders geeignet sind. Weiterhin ergibt sich wegen des Kohlenstoffgehaltes eine hohe chemische Affinität zu Schmiermitteln, so daß ein Schmierfilmabriß unter Hochlast vermieden werden kann. Bei den Kohlenstoffschichten ist jedoch nachteilig, daß metallhaltige Kohlenstoffschichten eine gute Haftung zu metallischen Bauteilen zeigen, dafür aber keine nennenswerte Härte aufweisen und metallfreie Kohlenstoffschichten je nach Wasserstoffgehalt von polymerweich bis diamanthart hergestellt werden können, diese jedoch eine relativ schlechte Haftung zu metallischen Bauteilen aufweisen. Somit sind mit den Kohlenstoffschichten versehene Bauteile wiederum nur für begrenzte Anwendungsfälle einsetzbar.

Aus der FR-A-2 596 775 ist ein ionenunterstütztes Plasmabeschichtungsverfahren bekannt, welches nach einer Vorreinigung durch Argonionenbeschuß eine Titanschicht durch Elektronenstrahlverdampfung unter gleichzeitigem Argonionenbeschuß aufbringt. Danach wird kontinuierlich das Prozeßgas Argon durch Stickstoff ersetzt, um eine TiN-Schicht zu erzeugen. Im weiteren wird dann das Prozeßgas Stickstoff kontinuierlich durch Benzol ersetzt und somit bei gleichzeitiger Titanverdampfung eine Ti(C,N)-Schicht erzeugt. Abschließend wird die Titanverdampfung und die Stickstoffzufuhr gestoppt, woraus eine Oberflächenschicht aus reinem i-Kohlenstoff resultiert. Die mit diesem Verfahren hergestellte Hartstoffschicht weist zwischen den einzelnen Teilbereichen fließende Übergänge auf. Die Temperatur des zu beschichtenden Substrates wird bei maximal 300°C gehalten. Der Nachteil dieses Verfahrens liegt in der Sprödheit der Oberflächenschicht und der diskontinuierlichen Grenzfläche zwischen der Ti(C, N)-Schicht und der Oberflächenschicht.

### Vorteile der Erfindung

Das Verfahren zur Herstellung einer Hartstoffschicht mit den im Anspruch 1 genannten Merkmalen hat den Vorteil, daß eine Verschleißschutzbeschichtung zur Verfügung gestellt werden kann, die vielseitig einsetzbar ist und den genannten unterschiedlichsten, gegebenenfalls kombinierten Verschleißarten eine hohe Widerstandskraft entgegensetzt. Dadurch, daß gleichzeitig während der Abscheidung der Hartstoffschicht eine energetische Ionenbehandlung erfolgt und die Beschichtungstemperatur lediglich bei ca. 200°C liegt, ist es sehr vorteilhaft möglich, selbst preiswerte und nicht temperaturbeständige Bauteilwerkstoffe mit einer universell verwendbaren Verschleißschutzbeschichtung zu versehen. Durch diese Kombination einer Schichtabscheidung mit einer energetischen Ionenbehandlung lassen sich auftretende Haftungs- oder Schichtbildungsprobleme zuverlässig lösen.

Die Schichtabscheidung mit veränderlichen Parametern, insbesondere der Abscheidedauer und der Prozeßgaszusammensetzung, und die energetische Ionenbehandlung zwischen einer niederenergetischen Ionenbestrahlung und einer hochenergetischen Ionenbehandlung (Ionenimplantation) erlaubt eine Vielzahl von Variationsmöglichkeiten, die gezielt auf das Bauteil und/oder das Beschichtungsmaterial abgestimmt werden können. Die fortschreitende, vorzugsweise kontinuierliche Parametervariation während der Herstellung der Hartstoffschicht garantiert einen inneren Zusammenhalt im Schichtverbund. Durch Variation der Schichtzusammensetzung, insbesondere in Verbindung mit einer gezielten niederenergetischen Ionenbestrahlung während der Beschichtung kann die gewünschte Härte, Struktur und Dichte der Schicht bei geringen inneren Spannungen eingestellt werden. Durch eine gleichzeitige oder ergänzende hochenergetische Ionenimplantation wird einerseits eine gute Schichthaftung zu dem zu beschichtenden Bauteil, selbst wenn dieses einen unterschiedlichen Bindungstyp aufweist, garantiert und andererseits eine gewünschte Struktur- und Dichteänderung erreicht. So kann beispielsweise bei Kohlenstoffschichten der diamantähnliche Charakter eingestellt werden. Das Spannungs-, Haftungs-, Härte- und somit auch das tribologische Verhalten des gesamten Schichtverbundes läßt sich sehr vorteilhaft durch Variation der Abscheidedauer bzw. der zeitlichen Länge der graduellen Übergänge den Umständen anpassen. Bei mit dem erfindungsgemäßen Verfahren beschichteten Bauteilen ist es vorteilhaft möglich, diese bei solchen Anwendungen einzusetzen, bei denen ein oft gekoppelter Gleit- und Ermüdungsverschleiß an tribologisch hoch belasteten Bauteilen wirksam bekämpft werden soll. Durch die fortschreitende, vorzugsweise kontinuierliche Verringerung des Titangehaltes in der Oberflächenschicht bei gleichzeitig forztschreitender, vorzugsweise kontinuierlicher Erhöhung des Kohlenstoffgehaltes sowie der Zugabe einer geringen Menge an Stickstoff wird weiterhin die Sprödheit der Oberflächenschicht sehr vorteilhaft vermindert.

Weitere vorteilhafte Ausgestaltungen der Erfindung ergeben sich aus den übrigen in den Unteransprüchen genannten Merkmalen.

### Zeichnung

Die Erfindung wird nachfolgend in einem Ausführungsbeispiel anhand der zugehörigen Zeichnungen erläutert. Es zeigen:
- Figur 1: schematisch eine Schnittdarstellung eines mit einer erfindungsgemäßen Hartstoffschicht beschichteten Bauteils;
- Figur 2: ein Zeitdiagramm der Partikelflüsse während der Schichtabscheidung
- Figur 3: ein Zeitdiagramm einer parallel verlaufenden Ionenbehandlung

### Beschreibung des Ausführungsbeispiels

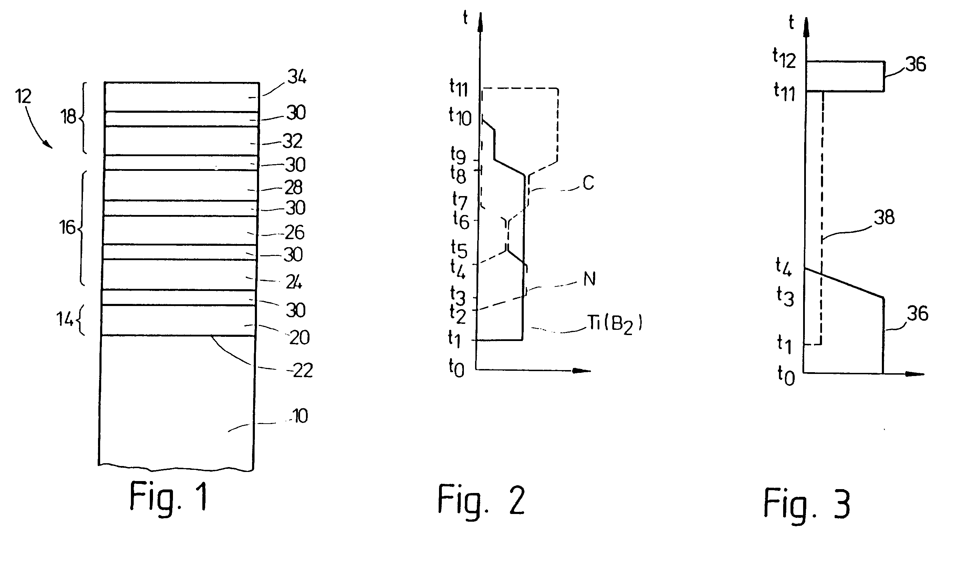

In Figur 1 ist ein Bauteil 10 gezeigt, das beispielsweise in mechanischen Steuer- und Regelbaugruppen, wie Einspritzanlagen, in der Kraftfahrzeugtechnik eingesetzt werden soll. Das Bauteil 10 unterliegt dabei sehr unterschiedlichen Verschleißarten. So soll das Bauteil 10 sowohl gegen eine schlagende Beanspruchung, beispielsweise bei einem Ventilsitz, gegen eine Kavitationserosion, beispielsweise bei hohen Flüssigkeitsdrücken, gegen Gleitbeanspruchung, beispielsweise in einem Lager, gegen schwingenden Ermüdungsverschleiß, beispielsweise von Regelkomponenten, gegen Abrasion, beispielsweise hervorgerufen in Gegenwart harter Verunreinigungspartikel, sowie gegen einen korrosiven Angriff, beispielsweise in Wasser, Salzlösungen, Lösungsmitteln, Kraftstoffen mit und ohne Zusätzen, geschützt sein. Die hier genannten möglichen Verschleißarten sind lediglich beispielhaft und sollen die Vielseitigkeit, die an den Schutz eines Bauteils 10 gestellt werden, verdeutlichen.

Das Bauteil 10 ist mit einer Hartstoffschicht 12 versehen, die sich aus einer Haftschicht 14, einer Funktionsschicht 16 und einer Oberflächenschicht 18 zusammensetzt. Dieser gesamte Schichtverbund mit einer Gesamtschichtdicke von beispielsweise ca. 3 µm weist innerhalb der einzelnen Schichten 14, 16 und 18 verschieden zusammengesetzte Bereiche auf. Die einzelnen Bereiche werden hier lediglich genannt und deren Erzeugung anhand der Figuren 2 und 3 näher erläutert. Die Haftschicht 14 besteht aus einem Bereich 20 auf Basis von Titan. Die Haftschicht 14 aus reinem Titan ist insbesondere geeignet, wenn das Bauteil 10 aus einem metallischen Substrat besteht, da Titan aufgrund seiner Oxydationsneigung in der Lage ist, die meist oxydischen Verunreinigungen auf einer Oberfläche 22 des Bauteils 10 einzubinden. Alternativ besteht die Haftschicht 14 aus Titanborid (TiB₂), wenn als Verdampfungsmaterial anstelle des Titans Titanborid eingesetzt wird, das für extrem harte und chemisch inerte Schichtsysteme zu bevorzugen ist.

Die Funktionsschicht 16 weist die Bereiche 24, 26 und 28 auf. Diese Bereiche bestehen aus einer Hartstofflegierung von Titannitriden (TiN) mit Titankarbiden (TiC) und/oder Titanboriden (TiB₂). Im gezeigten Beispiel, wo Titan als Aufdampfmaterial eingesetzt wird, besteht der Bereich 24 aus TiN, der Bereich 26 aus TiCN und der Bereich 28 aus TiC. Wird alternativ Titanborid als Verdampfungsmaterial eingesetzt, so besteht der Bereich 24 aus TiBN, der Bereich 26 aus TiBCN und der Bereich 28 aus TiBC. Durch die Kombination der Eigenschaften der vorgenannten binären Komponenten lassen sich die Gesamteigenschaften der Funktionsschicht 16 variieren. Beispielsweise läßt sich ein Kompromiß zwischen einer gesteigerten Schichthärte, einer reduzierten Sprödheit und geringen inneren Spannungen einstellen. Die hier mit 30 gekennzeichneten Übergänge zwischen den Bereichen 24, 26 und 28 weisen Mischzusammensetzungen der Bereiche 24, 26 und 28 auf, so daß sich ein allmählicher Übergang von einer Hartstofflegierung in eine andere ergibt.

Die Oberflächenschicht 18 besteht hauptsächlich aus dem Bereich 32 und optional aus dem Bereich 34. Der Bereich 32 besteht aus einer metallhaltigen Kohlenstoffschicht (a-C:Ti) und der Bereich 34 aus einer metallfreien Kohlenstoffschicht (a-C:H).

Anhand der Figuren 2 und 3 soll das Herstellungsverfahren und der Strukturaufbau der in Figur 1 gezeigten Hartstoffschicht 12 näher erläutert werden. Figur 2 zeigt dabei den Ablauf der Dampfpartikelflüsse während der Abscheidung der Hartstoffschicht, im Beispiel der Titanschicht bzw. der entsprechenden Titanlegierungen, über der Zeit und Figur 3 den Ablauf der energetischen Ionenbehandlung über der Zeit. Zu einem Zeitpunkt t₀ wird das Bauteil 10 mit einer Ionenbestrahlung 36 beaufschlagt. Besonders durch das Bombardement mit schweren Ionen vor der Schichtabscheidung wird eine Bauteiloberflächen-Sputtervorreinigung durchgeführt. Im abgebildeten Beispiel findet diese Bestrahlung mit Ionen aus einer separaten Ionenquelle und mit einer Energie größer 10 keV statt. Ein Vorteil der Hochenergie-Sputtervorreinigung ist, daß elektrostatische Effekte durch Ecken und Kanten wegen der gerichteten Ionenbewegung keine Rolle spielen. Prinzipiell ist auch ein NiederenergieIonenätzen bei 1000 eV geeignet, bei dem Ionen aus dem Beschichtungsplasma durch Anlegen einer Spannung auf die Substrate gelenkt werden. Bei stark strukturierten Substratgeometrien treffen die Ionen jedoch den elektrischen Feldlinien folgend verstärkt auf Kanten und gelangen kaum in Vertiefungen. Daher ist diese Art der NiederenergieIonenbestrahlung nur bei glatten Oberflächenstrukturen effektiv.

Nach der hoch- oder niederenergetischen Sputtervorreinigung ermöglicht eine hochenergetische Ionenbestrahlung ein atomares Durchmischen der Bauteiloberfläche 22 mit der nachfolgend aufzubringenden ersten Schicht. Hierdurch wird eine Haftungssteigerung und ein homogenes Schichtwachstum bei einer Beschichtungstemperatur von ca. 200 °C gewährleistet. Somit können mit dem erfindungsgemäßen Verfahren auch Bauteile 10 beschichtet werden, die einer höheren Beschichtungstemperatur nicht standhalten würden.

Zu einem Zeitpunkt t₁ wird die Abscheidung der Titan- bzw. der Titanborid (TiB₂)-Schicht begonnen. Gleichzeitig beginnt ab dem Zeitpunkt t₁ eine niederenergetische Bestrahlung 38 mit Ionen aus dem vorhandenen Beschichtungsplasma. Diese wird mit einer Energie von beispielsweise 100 eV durchgeführt. Zu einem Zeitpunkt t₂ wird die Prozeßgaszusammensetzung während der Schichtabscheidung so verändert, daß nunmehr Stickstoff (N₂) als Prozeßgas zugegeben wird. Der Stickstoffzusatz wird bis zum Zeitpunkt t₃ gesteigert und bleibt dann bis zu einem Zeitpunkt t₄ konstant. Von dem Zeitpunkt t₄ beginnend wird der Stickstoffeinsatz reduziert und ab einem Zeitpunkt t₇ auf einem Minimalwert gehalten. Für eine stickstofffreie Oberflächenschicht wird der Stickstoffzusatz zu dem Zeitpunkt t₇ vollständig eingestellt. Zum Zeitpunkt t₄ wird die Prozeßgaszusammensetzung so verändert, daß zusätzlich Kohlenstoff, beispielsweise in Form von Azetylen (C₂H₂) als Prozeßgas eingeführt wird, dessen Anteil bis zu einem Zeitpunkt t₁₁ stufenweise ansteigt und dann eingestellt wird. Durch diese Variation der Prozeßgaszusammensetzung wird erreicht, daß während einer bestimmten Zeitspanne lediglich Stickstoff als Prozeßgas zur Verfügung steht, während einer weiteren Zeitspanne ein Gemisch aus Kohlenstoff und Stickstoff in etwa gleichem Verhältnis zur Verfügung steht und während einer weiteren Zeitspanne hauptsächlich nur Kohlenstoff eventuell mit geringer Beimengung von Stickstoff zur Verfügung steht. Durch diese veränderten Prozeßplasmen wird erreicht, daß zunächst der Nitrid-Bereich 24 (Ti(B)N) als duktile Diffusionsbarriere für den Kohlenstoff entsteht, der in den Karbonitrid-Bereich 26 (Ti(B)C,N)) mit der gewünschten Härte und dann in den Karbid-Bereich 28 (Ti(B)C)) übergeht. Bei Verwendung von Titanborid als Aufdampfmaterial läßt sich der Boranteil in den einzelnen Bereichen 24, 26 und 28 der Schicht 16 nicht vollständig substituieren. Die optionale geringe Beimengung von Stickstoff zu den Karbidschichten 28 hilft deren Sprödheit zu reduzieren. Gleichzeitig mit der Variation der Prozeßgaszusammensetzung wird die niederenergetische Ionenbestrahlung 38 weitergeführt, während die hochenergetische Ionenbestrahlung 36 zum Zeitpunkt t₄ eingestellt wird. Die niederenergetische Ionenbestrahlung 38 bewirkt dabei während der Schichtabscheidung eine Strukturverdichtung der Funktionsschicht 16 bei geringen inneren Spannungen und gewährleistet die Einhaltung der Prozeßtemperatur von 200 °C. Dadurch, daß die hochenergetische Ionenbestrahlung 36 erst zum Zeitpunkt t₄ eingestellt wird, wird das atomare Durchmischen des Bauteils 10 mit der Haftschicht 14 und dem ersten Bereich 24 der Funktionsschicht 16 begünstigt.

Beginnend mit dem Zeitpunkt t₈ wird die Verdampfung des Titans bzw. des Titanborids (TiB₂) stufenweise verringert und optional zum Zeitpunkt t₁₀ eingestellt, falls eine metallfreie Kohlenstoffschicht erwünscht ist. Gleichzeitig wird die Zufuhr des Prozeßgases Kohlenstoff (C) verstärkt. Damit wird zur Oberflächenschicht 18 hin die Schichtzusammensetzung, ausgehend von dem Karbid-Bereich 28 (TiC bzw. TiBC), so geändert, daß zunächst der metallhaltige Bereich 32 (a-C:Ti) und dann optional der metallfreie Eereich 34 (a-C:H) einer Kohlenstoffschicht entsteht. Eine geringe Beimengung von Stickstoff zu den kohlenstoffreichen Schichten 32 und 34 hilft wiederum deren Sprödheit zu reduzieren.

Nach Beendigung der Schichtabscheidung zum Zeitpunkt t₁₁ kann nochmals eine hochenergetische Ionenbestrahlung 36 bis zum Zeitpunkt t₁₂ durchgeführt werden. Insbesondere durch die Implantation leichter Ionen wird der Wasserstoffgehalt der Oberflächenschicht 18 reduziert. Dadurch kann im nachhinein nochmals gezielt die Struktur und Dichte der Oberflächenschicht geändert werden, so daß sich der diamantähnliche Charakter einstellt. Dies bedeutet, daß eine porenfreie, chemisch resistente Abdeckung der harten Funktionsschicht 16 erreicht wird, die einen ausgezeichneten Schutz gegen korrosive Medien, wie beispielsweise Kraftstoffe, gewährleistet.

Nach allem wird klar, daß durch die beschriebene Kombination der Gasphasenabscheidung mit der energetischen Ionenbehandlung und der Variation der Prozeßparameter ein Schichtverbund geschaffen werden kann, der mit einer Haftschicht 14 beginnt, die durch graduelle Parametervariation kontinuierlich in eine harte Funktionsschicht 16 übergeht und schließlich mit einer reibmindernden Oberflächenschicht 18 abschließt. Insbesondere die diamantähnliche Oberflächenschicht 18 zeigt eine dichte Struktur und eignet sich aufgrund ihrer chemischen Resistenz gegen Säuren und Laugen hervorragend als Korrosionschutzschicht. Somit weist die Hartstoffschicht 12 insgesamt Eigenschaften auf, die eine Resistenz gegen die bereits erwähnten unterschiedlichen, oftmals kombinierten Verschleißarten bietet.

## Patentansprüche

1. Verfahren zum Beschichten eines Bauteils mit einer Hartstoffschicht durch Abscheiden von Titan oder einer Titanverbindung in einem kombinierten Niedertemperatur-PVD- und CVD-Beschichtungsverfahren, wobei das bei der Abscheidung verwendete Prozeßgas in veränderlichen Anteilen Stickstoff und Kohlenstoff enthält, um eine Haftschicht (14), darauf eine verschleißbeständige Funktionsschicht (16) und darauf eine reibmindernde Oberflächenschicht (18) zu erzeugen, **dadurch gekennzeichnet**, daß zur Erzeugung der Oberflächenschicht (18) der Anteil des in dem Prozeßgas enthaltenen Kohlenstoffs gegenüber dem bei der Erzeugung der Funktionsschicht (16) vorhandenen Anteil fortschreitend erhöht, der Anteil an Titan oder der Titanverbindung fortschreitend verringert wird, und dem Prozeßgas eine geringe Menge an Stickstoff beigegeben wird.

2. Verfahren nach Anspruch 1, **dadurch gekennzeichnet**, daß zwischen den Schichten (14, 16, 18) fließende Übergänge (30) erzeugt werden.

3. Verfahren nach Anspruch 1 oder 2, **dadurch gekennzeichnet**, daß als Verdampfungsmaterial Titan oder Titanborid eingesetzt wird, das während der Beschichtung mit einem Stickstoffgas, einem Kohlenstoffgas und/oder einem Gemisch aus Stickstoff- und Kohlenstoffgas reagiert.

4. Verfahren nach einem der vorhergehenden Ansprüche, **dadurch gekennzeichnet**, daß die Schichtabscheidung mit veränderlichen Parametern, insbesondere der Abscheidedauer und der Prozeßgaszusammensetzung, durchgeführt wird.

5. Verfahren nach einem der vorhergehenden Ansprüche, **dadurch gekennzeichnet**, daß zur Erzeugung der Haftschicht (14) das Verdampfungsmaterial nicht in Gegenwart eines Reaktivgases abgeschieden wird.

6. Verfahren nach einem der vorhergehenden Ansprüche, **dadurch gekennzeichnet**, daß zur Erzeugung der verschleißbeständigen Funktionsschicht (16) das Verdampfungsmaterial in etwa gleichem Maße wie die Reaktivgase abgeschieden wird.

7. Verfahren nach Anspruch 6, **dadurch gekennzeichnet**, daß nur das Stickstoffgas zur Erzeugung eines duktilen Bereiches (24) der Funktionsschicht (16) eingesetzt wird.

8. Verfahren nach Anspruch 6, **dadurch gekennzeichnet**, daß ein Gemisch aus etwa gleichen Anteilen von Stickstoff- und Kohlenstoffgas zur Erzeugung eines harten Bereiches (26) der Funktionsschicht (16) eingesetzt wird.

9. Verfahren nach Anspruch 6, **dadurch gekennzeichnet**, daß hauptsächlich das Kohlenstoffgas, eventuell mit geringen Beimengungen von Stickstoffgas, zur Erzeugung eines Übergangsbereiches (28) der Funktions- (16) zur Oberflächenschicht (18) eingesetzt wird.

10. Verfahren nach einem der vorhergehenden Ansprüche, **dadurch gekennzeichnet**, daß zur Erzeugung der reibmindernden Oberflächenschicht (18) hauptsächlich das Kohlenstoffgas, eventuell mit geringen Beimengungen von Stickstoffgas, eingesetzt wird.

11. Verfahren nach Anspruch 10, **dadurch gekennzeichnet**, daß im Bereich (32) der oberflächenschicht (18) ein geringer Metallanteil enthalten ist.

12. Verfahren nach Anspruch 10 und 11, **dadurch gekennzeichnet**, daß im Bereich (34) der Oberflächenschicht (18) kein Metallanteil enthalten ist.

13. Verfahren nach einem der vorhergehenden Ansprüche, **dadurch gekennzeichnet**, daß zur Einhaltung einer Beschichtungstemperatur von ca. 200 °C wahlweise eine niederenergetische Ionenbestrahlung (38) mit Ionenenergien unterhalb 1 keV und/oder eine hochenergetische Ionenimplantation (36) mit Ionenenergien oberhalb 10 keV durchgeführt wird.

14. Verfahren nach Anspruch 13, **dadurch gekennzeichnet**, daß zur Vorreinigung der Bauteiloberfläche (22) vor der Schichtabscheidung eine Behandlung mit schweren Ionen eingesetzt wird.

15. Verfahren nach Anspruch 13 oder 14, **dadurch gekennzeichnet**, daß ein niederenergetischer Beschuß mit Ionen aus verstärkt ionisierten Plasmen von Beschichtungsquellen erfolgt, die jedoch nur mit geringster Leistung betrieben werden.

16. Verfahren nach Anspruch 13 oder 14, **dadurch gekennzeichnet**, daß ein hochenergetischer Beschuß mit gerichteten Ionen aus einer separaten Ionenquelle erfolgt.

17. Verfahren nach einem der vorhergehenden Ansprüche, **dadurch gekennzeichnet**, daß zur Steigerung der Schichthaftung zu Beginn der Schichtabscheidung während der Bereiche (20, 24) eine Implantation hochenergetischer Ionen aus einer separaten Ionenquelle durchgeführt wird.

18. Verfahren nach einem der vorhergehenden Ansprüche, **dadurch gekennzeichnet**, daß zur Verdichtung der Schichtstruktur parallel zu der Schichtabscheidung während der Schichten (14, 16, 18) ein niederenergetischer Beschuß mit Ionen aus vorhandenen Beschichtungsplasmen erfolgt.

19. Verfahren nach einem der vorhergehenden Ansprüche, **dadurch gekennzeichnet**, daß zur Reduktion des Wasserstoffgehaltes der Oberflächenschichten nach Beendigung der Schichtabscheidung der Hartstoffschicht (12) ein Beschuß mit hochenergetischen leichten Ionen aus einer separaten Ionenquelle erfolgt.

20. Verfahren nach einem der vorhergehenden Ansprüche, **dadurch gekennzeichnet**, daß sämtliche Beschichtungs- und Ionenbestrahlungsparameter kontinuierlich verändert werden.

21. Hartstoffschicht, **dadurch gekennzeichnet**, daß sie nach einem der Ansprüche 1 bis 20 hergestellt wird.

## Claims

1. Process for coating a component with a hard material layer by depositing titanium or a titanium compound in a combined low-temperature PVD and CVD coating process, the process gas used during the deposition containing nitrogen and carbon in variable proportions, in order to fabricate an adhesion layer (14), on top of that a wear-resistant functional layer (16) and, on top of that, a friction-reducing surface layer (18), characterized in that in order to fabricate the surface layer (18), the proportion of carbon contained in the process gas is progressively increased compared with the proportion present during the fabrication of the functional layer (16), the proportion of titanium or of the titanium compound is progressively reduced, and a small quantity of nitrogen is admixed with the process gas.

2. Process according to Claim 1, characterized in that smooth transitions (30) are fabricated between the layers (14, 16, 18).

3. Process according to Claim 1 or 2, characterized in that the material to be evaporated that is used is titanium or titanium boride, which reacts during the coating with a nitrogen gas, a carbon gas and/or a mixture of nitrogen and carbon gas.

4. Process according to one of the preceding claims, characterized in that the layer deposition is carried out with variable parameters, in particular the deposition duration and the process gas composition.

5. Process according to one of the preceding claims, characterized in that in order to fabricate the adhesion layer (14), the material to be evaporated is not deposited in the presence of a reactive gas.

6. Process according to one of the preceding claims, characterized in that in order to fabricate the wear-resistant functional layer (16), the material to be evaporated is deposited to approximately the same extent as the reactive gases.

7. Process according to Claim 6, characterized in that only the nitrogen gas is used in order to fabricate a ductile region (24) of the functional layer (16).

8. Process according to Claim 6, characterized in that a mixture of approximately identical proportions of nitrogen and carbon gas is used in order to fabricate a hard region (26) of the functional layer (16).

9. Process according to Claim 6, characterized in that principally the carbon gas, possibly with small admixtures of nitrogen gas, is used in order to fabricate a transition region (28) between the functional layer (16) and the surface layer (18).

10. Process according to one of the preceding claims, characterized in that principally the carbon gas, possibly with small admixtures of nitrogen gas, is used in order to fabricate the friction-reducing surface layer (18).

11. Process according to Claim 10, characterized in that a small proportion of metal is contained in the region (32) of the surface layer (18).

12. Process according to Claims 10 and 11, characterized in that no proportion of metal is contained in the region (34) of the surface layer (18).

13. Process according to one of the preceding claims, characterized in that in order to keep to a coating temperature of approximately 200°C, optionally a low-energy ion irradiation (38) with ion energies of below 1 keV and/or a high-energy ion implantation (36) with ion energies of above 10 keV are carried out.

14. Process according to Claim 13, characterized in that in order to pre-clean the component surface (22), prior to the layer deposition, a treatment with heavy ions is used.

15. Process according to Claim 13 or 14, characterized in that a low-energy bombardment with ions from intensified ionized plasmas of coating sources is effected, the latter being operated only with extremely low power, however.

16. Process according to Claim 13 or 14, characterized in that a high-energy bombardment with directed ions from a separate ion source is effected.

17. Process according to one of the preceding claims, characterized in that in order to increase the layer adhesion, at the beginning of the layer deposition during the regions (20, 24) an implantation of high-energy ions from a separate ion source is carried out.

18. Process according to one of the preceding claims, characterized in that in order to densify the layer structure, in parallel with the layer deposition during the layers (14, 16, 18), a low-energy bombardment with ions from coating plasmas that are present is effected.

19. Process according to one of the preceding claims, characterized in that in order to reduce the hydrogen content of the surface layers, after the end of the layer deposition of the hard material layer (12), a bombardment with high-energy light ions from a separate ion source is effected.

20. Process according to one of the preceding claims, characterized in that all the coating and ion irradiation parameters are continuously varied.

21. Hard material layer, characterized in that it is produced according to one of Claims 1 to 20.

## Revendications

1. Procédé de revêtement d'une pièce avec une couche de matière dure, par dépôt de titane ou d'une combinaison de titane, selon un procédé de revêtement PVD-CVD combiné à basse température, le gaz de procédé utilisé pour le dépôt contenant des proportions variables d'azote et de carbone, pour former une couche d'accrochage (14) recevant une couche fonctionnelle (16) résistant à l'usure et celle-ci recevant une couche de surface (18) réduisant le frottement,
caractérisé en ce que
pour créer la couche .de surface (18) on augmente la teneur en carbone contenue dans le gaz de procédé par rapport à la teneur existant pour former la couche fonctionnelle (16), on diminue progressivement la teneur en titane ou la combinaison de titane, et on ajoute au gaz de procédé une faible quantité d'azote.

2. Procédé selon la revendication 1,
caractérisé en ce qu'
on crée des transitions continues entre les couches (14, 16, 18).

3. Procédé selon la revendication 1 ou 2,
caractérisé en ce que
comme matière d'évaporation, on utilise du titane ou du borure de titane qui réagit pendant le revêtement avec de l'azote gazeux, du carbone à l'état gazeux et/ou un mélange d'azote et de carbone à l'état gazeux.

4. Procédé selon l'une quelconque des revendications précédentes,
caractérisé en ce que
le dépôt de la couche se fait avec des paramètres variables, notamment la durée du dépôt et la composition du gaz de procédé.

5. Procédé selon l'une quelconque des revendications précédentes,
caractérisé en ce que
pour générer la couche d'accrochage (14), on dépose la matière de vaporisation en l'absence d'un gaz réactif.

6. Procédé selon l'une quelconque des revendications précédentes,
caractérisé en ce que
pour former la couche fonctionnelle (16) résistant à l'usure, on dépose la matière de vaporisation sensiblement selon la même mesure que les gaz réactifs.

7. Procédé selon la revendication 6,
caractérisé en ce qu'
on utilise seulement de l'azote gazeux pour créer une zone ductile (24) de la couche fonctionnelle (16).

8. Procédé selon la revendication 6,
caractérisé en ce qu'
on utilise un mélange comprenant sensiblement les mêmes parties d'azote et de carbone gazeux pour former une couche dure (26) de la couche fonctionnelle (16).

9. Procédé selon la revendication 6,
caractérisé en ce qu'
on utilise principalement du carbone gazeux, éventuellement avec une faible adjonction d'azote, pour former une zone transitoire (28) de la couche fonctionnelle (16) vers la couche de surface (18).

10. Procédé selon l'une quelconque des revendications précédentes,
caractérisé en ce que
pour former la couche de surface (18) réduisant le frottement, on utilise principalement du carbone gazeux éventuellement avec de faibles adjonctions d'azote gazeux.

11. Procédé selon la revendication 10,
caractérisé en ce que
la zone (32) de la couche de surface (18) contient une faible teneur en métal.

12. Procédé selon les revendications 10 et 11,
caractérisé en ce que,
la zone (34) de la couche de surface (18) ne contient pas de métal.

13. Procédé selon l'une quelconque des revendications précédentes,
caractérisé en ce que
pour respecter une température de revêtement d'environ 200°C, on effectue sélectivement une irradiation ionique à faible énergie (38) avec des énergies d'ions, inférieures à 1 keV et/ou une implantation ionique fortement énergétique (36) avec des énergies d'ions supérieures à 10 keV.

14. Procédé selon la revendication 13,
caractérisé en ce que
pour nettoyer préalablement la surface (22) de la pièce, avant le dépôt d'une couche, on effectue un traitement avec des ions lourds.

15. Procédé selon la revendication 13 ou 14,
caractérisé en ce qu'
on effectue un tir faiblement énergétique avec des ions d'un plasma à ionisation renforcée provenant de sources de revêtement qui ne fonctionnent toutefois qu'à puissance minimale.

16. Procédé selon la revendication 13 ou 14,
caractérisé en ce qu'
on effectue un tir fortement énergétique avec des ions dirigés provenant d'une source d'ions distincte.

17. Procédé selon l'une quelconque des revendications précédentes,
caractérisé en ce que
pour augmenter l'accrochage de la couche au début du dépôt de la couche, dans les zones (20, 24), on effectue une implantation d'ions fortement énergétique à partir d'une source d'ions séparée.

18. Procédé selon l'une des revendications précédentes,
caractérisé en ce que
pour compacter la structure de la couche, en parallèle au dépôt de la couche, on effectue un tir faiblement énergétique pour les couches (14, 16, 18), avec des ions provenant des plasmas de revêtement existants.

19. Procédé selon l'une quelconque des revendications précédentes,
caractérisé en ce que
pour réduire la teneur en hydrogène des couches de surfaces, à la fin du dépôt de la couche de matière dure (12), on effectue un tir fortement énergétique, avec des ions légers, provenant d'une source d'ions distincte.

20. Procédé selon l'une quelconque des revendications précédentes,
caractérisé en ce qu'
on modifie en continu tous les paramètres de revêtement et d'irradiation ionique.

21. Couche de matière dure,
caractérisée en ce qu'
elle résulte de la mise en oeuvre du procédé selon l'une quelconque des revendications 1 à 20.
